# EUROPÄISCHE PATENTSCHRIFT

(11) **EP 3 409 085 B1**
(45) Veröffentlichungstag und Bekanntmachung des Hinweises auf die Patenterteilung: **19.05.2021**
(21) Anmeldenummer: 17702036.9
(22) Anmeldetag: 24.01.2017
(51) Int. Cl.: H05K 7/20, F04D 27/00, F04D 33/00, F21V 29/63

(54) **ELEKTRISCHE ANORDNUNG FÜR EIN KRAFTFAHRZEUG, KRAFTFAHRZEUG UND VERFAHREN ZUM BETREIBEN EINES SYNTHETISCHEN JETS**
ELECTRIC ARRANGEMENT FOR A MOTOR VEHICLE, MOTOR VEHICLE, AND METHOD FOR OPERATING A SYNTHETIC JET
SYSTÈME ÉLECTRIQUE CONÇU POUR UN VÉHICULE AUTOMOBILE, VÉHICULE AUTOMOBILE ET PROCÉDÉ POUR FAIRE FONCTIONNER UN JET SYNTHÉTIQUE

(30) Priorität: 26.01.2016 DE 102016000812
(43) Veröffentlichungstag der Anmeldung: 05.12.2018
(73) Patentinhaber: Audi AG, 85045 Ingolstadt (DE)
(72) Erfinder: NEUKAM, Johannes, 91257 Pegnitz (DE)
(86) Internationale Anmeldenummer: PCT/EP2017/051366
(87) Internationale Veröffentlichungsnummer: WO 2017/129539

(56) Entgegenhaltungen:
- US-A1- 2009 167 109
- US-A1- 2010 012 301
- US-A1- 2012 098 424
- US-A1- 2015 115 846

## Beschreibung

Die Erfindung betrifft eine elektrische Anordnung für ein Kraftfahrzeug, umfassend eine ein elektrisches Bauelement aufweisende Baugruppe und einen zum Erzeugen von Fluidstößen ausgebildeten synthetischen Jet, welche zur Abgabe der Fluidstöße in Richtung der Baugruppe angeordnet ist.

Reale elektrische Bauelemente erzeugen während ihres Betriebs stets Abwärme, die üblicherweise unerwünscht ist und vom Bauelement durch technische Maßnahmen abgeführt wird. So entsteht beispielsweise bei dem Betrieb von Leuchtdioden, die in jüngerer Zeit auch vermehrt für Beleuchtungsanwendungen in Kraftfahrzeugen eingesetzt werden, neben der vorgesehenen Lichtemission auch Wärme, die abzuführen ist, um die Leuchtdiode innerhalb ihrer zugelassenen Betriebsparameter zu betreiben. Zur Verbesserung der Wärmeübertragung an ein Kühlfluid, typischerweise Luft, ist es bekannt, die Leuchtdiode mit einem Kühlkörper zu einer Baugruppe zusammenzufassen und diese durch einen synthetischen Jet zu kühlen. Ein solcher synthetischer Jet kann beispielsweise einen Hohlkörper umfassen, in dem eine Membran vibriert und dadurch periodisch einen Unter- und Überdruck des Kühlfluids erzeugt. Die dabei entstehenden Fluidstöße werden in Richtung der Baugruppe abgegeben und bewirken so eine Abfuhr der beim Betrieb des Bauelements erzeugten Abwärme.

Die US 2012/0098424 A1 beschreibt ein Beleuchtungssystem mit einer Lichtquelle, einem thermischen Managementsystem und eine Treiberelektronik, welche in einer Gehäusestruktur angeordnet sind. Das thermische Managementsystem weist eine Vielzahl synthetischer Jets auf.

Bei bekannten elektrischen Anordnungen wird der synthetische Jet jedoch weitestgehend unabhängig vom zu kühlenden Bauelement betrieben, so dass die Abgabe der Fluidstöße nicht an sein aktuelles Betriebsverhalten angepasst ist. Dies beeinträchtigt die Kühlleistung der elektrischen Anordnung erheblich.

Aus US 2015/115846 A1 ist eine piezoelektrische Kühlungssteuerungseinrichtung bekannt, umfassend eine Temperaturerfassungseinheit zur Erfassung der Temperatur einer Heizeinrichtung des zu kühlenden Gegenstands. Basierend auf der erfassten Temperatur wird geprüft, ob die piezoelektrische Kühleinrichtung aktiviert werden muss. Ferner ist eine Einstelleinheit vorgesehen, über die Pulsparameter basierend auf einem definierten Temperatureinstellbereich und der erfassten Temperatur der Heizeinrichtung festgelegt werden können. Eine Pulssteuereinheit generiert eine pulsweitenmodulierte Wellenform basierend auf den festgelegten Pulsparametern und gibt diese Ansteuerwelle aus. Eine piezoelektrische Kühleinheit nimmt sodann die piezoelektrisch gesteuerte Kühlung basierend auf der pulsweitenmoduliertren Steuerungswelle vor.

Ferner ist aus US 2009/0167109 A1 eine piezoelektrische Pumpe mit einem Pumpenkörper bekannt. Der Pumpenkörper weist eine Öffnung zum Zuführen eines Fluids von außerhalb des Gehäuses und zur Ausbildung eines Flüssigkeitsjets im Inneren auf. Ferner ist eine Wand vorgesehen, die benachbart zu der Öffnung angeordnet ist sowie ein piezoelektrischer Körper, der an der Wand angeordnet ist, um diese zum Vibrieren zu bringen. Über eine Erfassungseinrichtung kann die Durchflussrate des Fluids durch die Öffnung erfasst werden. Über eine Steuereinheit schließlich wird die Antriebseinheit des piezoelektrischen Körpers entsprechend angesteuert, worüber die Durchflussrate des Fluids entsprechend eingestellt werden kann.

Der Erfindung liegt mithin die Aufgabe zu Grunde, eine Möglichkeit zum Betreiben einer elektrischen Anordnung mit einer verbesserten Kühlleistung anzugeben.

Zur Lösung dieser Aufgabe ist bei einer elektrischen Anordnung der eingangs genannten Art erfindungsgemäß vorgesehen, dass das Bauelement gemäß einem zeitlichen Signalverlaufs aktivierbar und der synthetische Jet zum mit einer jeweiligen Aktivierung des Bauelements synchronisierten Erzeugen wenigstens eines Fluidstoßes ansteuerbar ist.

Die Erfindung beruht auf der Überlegung, den synthetischen Jet zu solchen Zeitpunkten zur Erzeugung des Fluidstoßes anzusteuern, in denen das Bauelement gemäß dem zeitlichen Signalverlauf aktiviert ist und so eine besonders hohe Wärmemenge erzeugt. Durch das Abgeben des Fluidstoßes in Richtung der Baugruppe kann diese erhöhte Wärmemenge mit einem besonders großen Wärmeübertragungskoeffizienten abgeführt und so ein höherer Abwärmestrom als bei herkömmlichen elektrischen Anordnungen erzielt werden. Der zeitliche Signalverlauf ist dabei selbstverständlich periodisch oder zumindest in einem kurzen Zeitabschnitt von beispielsweise weniger als einer Sekunde, bevorzugt weniger als 100 Millisekunden, alternierend. Es erfolgt also während der Periodendauer oder des Zeitabschnitts eine Aktivierung und eine Deaktivierung des Bauelements, wobei der synthetische Jet mit jeder Aktivierung des Bauelements zum Erzeugen eines synchronen Fluidstoßes ansteuerbar ist. Insbesondere kann vorgesehen sein, dass während der Deaktivierung kein Fluidstoß abgebbar ist.

Der synthetische Jet selbst umfasst bevorzugt wenigstens eine Membran, die elastisch und/oder flexibel verformbar und mittels eines Stellmittels, insbesondere eines piezoelektrischen Elements, zum Erzeugen des Fluidstoßes bewegbar ist. Das Bauelement kann beispielsweise eine Lichtquelle sein, wobei es bei seiner Aktivierung elektrische Energie in Strahlungsenergie im sichtbaren Bereich umwandelt. Das Bauelement kann aber auch allgemein ein Halbleiterbauelement sein, bei dessen Aktivierung Abwärme entsteht. Zweckmäßigerweise sind die Baugruppe und der synthetische Jet auf oder an einem Trägerkörper der elektrischen Anordnung angebracht. Für die Ansteuerung des synthetischen Jets ist zweckmäßigerweise eine Steuereinrichtung vorgesehen.

Bei der erfindungsgemäßen elektrischen Anordnung wird vorteilhafterweise der kühlende Fluidstoß genau zu solchen Zeitpunkten erzeugt, in denen das Bauelement eine besonders hohe Wärmeentwicklung aufweist. Über den gesamten zeitlichen Signalverlauf wird somit eine optimierte Kühlstrategie realisiert, wohingegen bei herkömmlichen elektrischen Anordnungen ohne Synchronisierung ein zeitliches Aufeinandertreffen der Fluidstoßabgabe und der Aktivierung des Bauelements weitestgehend zufällig ist. Dies bewirkt eine wesentliche Effizienzsteigerung bei der Kühlleistung der elektrischen Anordnung.

Zudem werden für das Bauelement herstellerseitig häufig unterschiedliche zulässige Betriebstemperaturen angegeben. So ist die maximale Betriebssperrschichttemperatur θ_{J},ₘₐₓ (Maximum Operation Junction Temperature) bekannt, die im Dauerbetrieb des Bauelements nicht überschritten werden soll, um seine Lebensdauer nicht zu verkürzen. Daneben wird typischerweise auch die absolute maximale Sperrschichttemperatur (Absolute Maximum Junciton Temperature) angegeben, bei deren Erreichen sofort oder zeitnah mit einer Schädigung des Bauelement zu rechnen ist. Da stets ein Betrieb des Bauelements unterhalb jedoch für eine größtmögliche Leistungsausbeute nah bei der θ_{J},ₘₐₓ angestrebt wird, kann durch die synchronisierte Ansteuerung des synthetischen Jets für jede Aktivierung des Bauelements ein Erreichen dieser Temperatur vermieden werden. Gleichzeitig kann das Bauelement deutlich näher an seiner Leistungsgrenze betrieben werden, als dies bei unsynchronisierten elektrischen Anordnungen der Fall ist.

Es wird bei der erfindungsgemäßen elektrischen Anordnung bevorzugt, wenn das Bauelement eine Leuchtdiode und/oder eine Laserdiode ist oder umfasst. Bei solchen Lichtquellen als Bauelement ist nämlich durch die Vorgabe des zeitlichen Signalverlaufs die vom menschlichen Auge wahrgenommene Helligkeit einstellbar. Dementsprechend ist es bei der erfindungsgemäßen elektrischen Anordnung zweckmäßig, wenn mittels des Signalverlaufs eine für das menschliche Auge als homogen wahrgenommene scheinbare Helligkeit des Licht emittierenden Bauelements vorgebbar ist. Mit anderen Worten ist der Zeitabschnitt des zeitlichen Signalverlaufs, in dem das Bauelement aktiviert und deaktiviert wird so kurz, dass ein menschlicher Betrachter mit bloßem Auge die Aktivierung und Deaktivierung nicht als Helligkeitsänderung wahrnimmt. Da eine solche Ansteuerung von lichtemittierenden Bauelementen grundsätzlich bekannt ist, lässt sich das erfindungsgemäße Prinzip der synchronisieren Ansteuerung des synthetischen Jets so besonders einfach in bekannter Steuerkonzepte integrieren.

Außerdem ist es besonders zweckmäßig, wenn der zeitliche Signalverlauf eine Pulsweitenmodulation beschreibt. Dabei wird das Bauelement mit einer Folge von Rechtecksignalen oder sehr steilflankigen Trapezsignalen vorgegebener Periodendauer angesteuert, wobei mittels eines Tastverhältnisses die Dauer einer jeweiligen Aktivierung des Bauelements vorgebbar ist. Bei einem lichtemittierenden Bauelement lässt sich so besonders einfach wie zuvor beschrieben die wahrgenommene scheinbare Helligkeit vorgeben und über die Zeit variieren.

Um eine besonders hohe Wärmeabfuhr von dem Bauelement zu ermöglichen wird es bei der erfindungsgemäßen elektrischen Anordnung bevorzugt, wenn der synthetische Jet zur Abgabe des Fluidstoßes auf oder an einen mit dem Bauelement thermisch verbundenen Wärmeleitkörper angeordnet ist. Der Wärmeleitkörper, der auch als Kühlkörper bezeichnet werden kann, ist bevorzugt aus einem thermisch gut leitfähigen Material wie Aluminium oder Kupfer gebildet und kann beispielsweise Rippen oder andere zur Vergrößerung seiner mit dem Fluidstoß wechselwirkenden Oberfläche ausgebildete Wärmeleitelemente aufweisen. Alternativ oder zusätzlich kann aber auch vorgesehen sein, dass der synthetische Jet zur Abgabe des Fluidstoßes auf das Bauelement selbst angeordnet ist. In diesem Fall erfolgt die Wärmeübertragung von dem Bauelement an das Fluid unmittelbar, gegebenenfalls über ein Gehäuse des Bauelements.

Eine besonders aufwandsarme Realisierung des synthetischen Jets lässt sich erzielen, wenn dieser zum Ausstoßen von Luft als Fluidstoß ausgebildet ist. Es ist aber auch denkbar, dass der synthetische Jet zum Ausstoßen anderer gasförmiger Fluide ausgebildet ist oder als Teil eines mit einer Flüssigkeit betriebenen Kühlkreislaufs angeordnet ist.

Es kann zudem mit Vorteil vorgesehen sein, dass der synthetische Jet derart ansteuerbar ist, dass der wenigstens eine Fluidstoß nach dem Beginn der Aktivierung des Bauelements auf der Baugruppe auftrifft. Es liegt dann mithin eine bestimmte Zeitspanne zwischen der erfolgten Aktivierung des Bauelements und dem Zeitpunkt, zu dem der Fluidstoß die Baugruppe erreicht. Die Baugruppe erwärmt sich so zunächst und kann dann zur Wärmeübertragung mit dem auftreffenden Fluidstoß wechselwirken. Die Baugruppe hat zum Zeitpunkt des Auftreffens des Fluidstoßes folglich bereits ausreichend Wärme entwickelt, um eine möglichst hohe Wärmemenge abzuführen. Bevorzugt ist der Zeitpunkt der Abgabe des Fluidstoßes so gewählt, dass seine Intensität an der Baugruppe ihr Maximum erreicht, wenn die θ_{J,max} des Bauelement erreicht ist. Selbstverständlich ist bei der Bestimmung des Zeitpunkts der Abgabe des Fluidstoßes die räumliche Anordnung, insbesondere der Abstand des synthetischen Jets zur Baugruppe zu berücksichtigen, da sich der Fluidstoß mit einer stoffabhängigen Ausbreitungsgeschwindigkeit fortpflanzt.

Bei der erfindungsgemäßen elektrischen Anordnung kann auch eine Steuereinrichtung vorgesehen sein, mittels welcher das Bauelement ansteuerbar ist. Insbesondere kann die Steuereinrichtung mit dem Bauelement und dem synthetischen Jet auf oder an dem Trägerkörper angeordnet und identisch mit der zuvor genannten Steuereinrichtung für die Ansteuerung des synthetischen Jets sein. Die Steuereinrichtung kann dabei eine zum Erzeugen des zeitlichen Signalverlaufs ausgebildete Signalerzeugungseinheit aufweisen. D.h., dass der Signalverlauf, gemäß welchem das Bauelement aktiviert und deaktiviert wird, von der elektrischen Anordnung selbst erzeugt wird. Insbesondere kann die Signalerzeugungseinheit dazu ausgebildet sein, die Pulsweitenmodulation aus einem externen, analogen oder digitalen Steuersignal zu erzeugen und damit das Bauelement anzusteuern.

Es kann bei der elektrischen Anordnung mit der Steuereinrichtung zudem eine Erfassungseinheit vorgesehen sein, mittels welcher die Aktivierung des

Bauelements erfassbar ist, wobei die erfasste Aktivierung des Bauelements durch eine Verarbeitungseinheit der Steuereinrichtung zum Ansteuern des synthetischen Jets auswertbar ist. Die Ansteuerung des synthetischen Jets erfolgt mithin in Abhängigkeit eines von der Erfassungseinheit erfassten Betriebszustands des Bauelements. Es wird mithin kein dediziertes Steuersignal für den synthetischen Jet selbst empfangen, sondern von der Steuereinrichtung der elektrischen Anordnung in Abhängigkeit der Aktivierung des Bauelements erzeugt. Dazu kann die Erfassungseinheit einen Sensor zum Erfassen einer Änderung einer Strahlungsstärke des elektromagnetische Wellen, insbesondere Licht, emittierenden Bauelements umfassen. Der Sensor kann beispielsweise ein fotoelektrisches Element sein, welches den Anstieg der Strahlungsstärke erfasst und daraus ein Aktivieren des Bauelements beschreibendes Sensorsignal erzeugt, wonach der synthetische Jet zur Abgabe des Fluidstoßes angesteuert wird. Alternativ oder zusätzlich kann die Erfassungseinheit einen Sensor zum Erfassen einer Änderung der Leistungsaufnahme des Bauelements umfassen. Dies kann beispielsweise durch Messen des durch das Bauelement fließenden Stroms und/oder der am Bauelement anliegenden Spannung erfolgen, woraus sich ebenfalls ein Rückschluss auf die Aktivierung des Bauelement ableiten lässt und der synthetische Jet entsprechend angesteuert werden kann.

Daneben betrifft die Erfindung ein Kraftfahrzeug, umfassend eine erfindungsgemäße elektrische Anordnung. Die elektrische Anordnung kann insbesondere von einem Bordnetz des Kraftfahrzeugs versorgt sein. Bevorzugt ist das Bauelement eine Lichtquelle und in einer Beleuchtungseinheit des Kraftfahrzeugs verbaut.

Außerdem betrifft die Erfindung ein Verfahren zum Betreiben eines synthetischen Jets, welcher Fluidstöße erzeugt und in Richtung einer einen elektrischen Bauelement aufweisenden Baugruppe abgibt. Das erfindungsgemäße Verfahren zeichnet sich dadurch aus, dass der synthetische Jet wenigstens einen Fluidstoß synchronisiert mit einer gemäß einem zeitlichen Signalverlauf erfolgenden jeweiligen Aktivierung des Bauelements erzeugt.

Im Rahmen des erfindungsgemäßen Verfahrens wird es bevorzugt, wenn der wenigstens eine Fluidstoß auf das Bauelement und/oder auf ein mit dem Bauelement thermisch verbundenen Wärmeleitkörper abgegeben wird.

Es kann ferner mit Vorteil vorgesehen sein, dass die Aktivierung des Bauelements erfasst wird und in Abhängigkeit der Erfassung der Aktivierung das Erzeugen des wenigstens einen Fluidstoßes erfolgt. Dabei ist es besonders bevorzugt, wenn zum Erfassen der Aktivierung eine Strahlungsstärke des elektromagnetische Wellen erzeugenden Bauelements und/oder eine Leistungsaufnahme des Bauelements gemessen wird.

Bei dem erfindungsgemäßen Verfahren ist es schließlich auch vorteilhaft, wenn der wenigstens eine abgegebene Fluidstoß nach dem Beginn der Aktivierung des Bauelements auf die Baugruppe auftrifft.

Sämtliche Ausführungen zur erfindungsgemäßen elektrischen Anordnung lassen sich analog auf das erfindungsgemäße Kraftfahrzeug und das erfindungsgemäße Verfahren übertragen, so dass auch mit diesen die zuvor genannten Vorteile erzielt werden können.

Weitere Einzelheiten und Vorteile der Erfindung ergeben sich aus dem im Folgenden beschriebenen Ausführungsbeispielen sowie anhand der Zeichnungen. Diese sind schematische Darstellungen und zeigen:
- Fig. 1: eine Prinzipskizze einer erfindungsgemäßen elektrischen Anordnung;
- Fig. 2: ein Diagramm des zeitlichen Verlaufs einer Stromstärke durch eine Leuchtdiode, ihrer Sperrschichttemperatur und der Intensität von Fluidstößen über die Zeit; und
- Fig. 3: eine Prinzipskizze eines erfindungsgemäßen Kraftfahrzeugs.

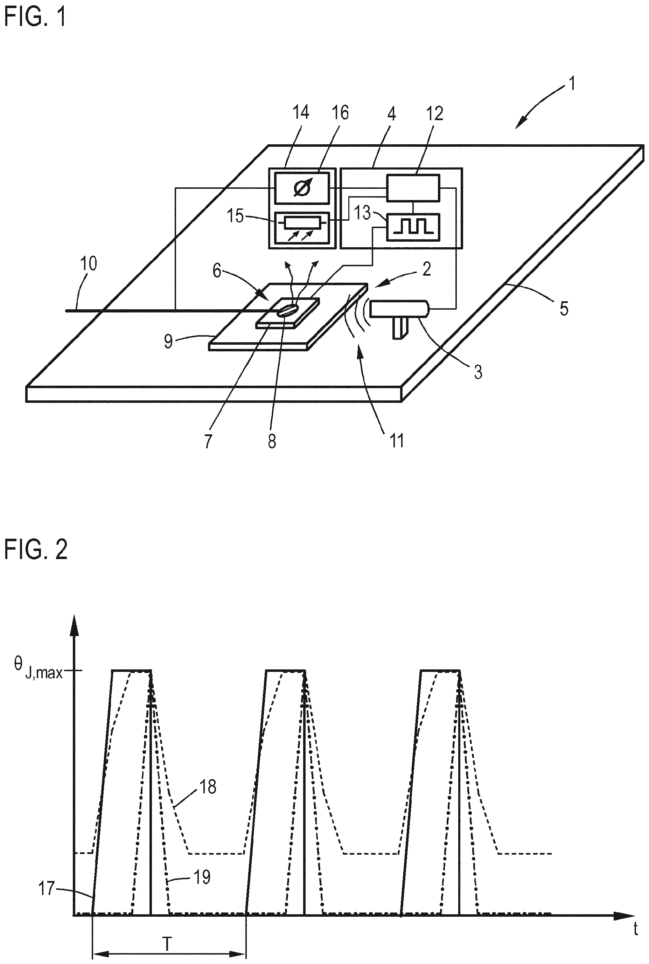

Fig. 1 zeigt eine Prinzipskizze einer elektrischen Anordnung 1, umfassend eine Baugruppe 2, einen synthetischen Jet 3 und eine Steuereinrichtung 4, welche lediglich rein schematisch mit ihren Funktionskomponenten dargestellt ist. Die Steuereinrichtung 4 ist als integrierter Schaltkreis, beispielsweise als Mikrocontroller oder anwendungsspezifischer Schaltkreis (ASIC), ausgebildet und mit der Baugruppe 2 und dem synthetischen Jet 3 auf einem Trägerkörper 5 angeordnet.

Die Baugruppe 2 weist ein Bauelement 6 in Form einer in einem Gehäuse 7 aufgenommenen Leuchtdiode 8 sowie einen Wärmeleitkörper 9 auf, der mit der Leuchtdiode 8 über ihr Gehäuse 7 thermisch gekoppelt ist und während ihres Betriebs erzeugte Wärme an die Umgebungsluft abgibt. Über eine externe Zuleitung 10 ist die Leuchtdiode 8 mit elektrischer Energie versorgbar.

Der synthetische Jet 3 ist auf die Baugruppe 2 gerichtet und zur Abgabe von Fluidstößen 11, die auf das Bauelement 6 und den Wärmeleitkörper 9 auftreffen, angeordnet. Dazu weist der synthetische Jet 3 beispielsweise eine Membran auf, die mittels eines piezoelektrischen Elements elastisch verformbar ist und bei einem Schwingen innerhalb eines Hohlraums den Fluidstoß erzeugt. Es sind aber auch andere aus dem Stand der Technik bekannte Bauformen für den synthetischen Jet 3 denkbar. Mit jedem Fluidstoß 11 gelangt so Luft auf die Baugruppe 2, die sich durch die Abwärme der Leuchtdiode 8 erwärmt und infolge der mit dem Fluidstoß 11 einhergehenden Luftbewegung abgeführt wird.

Die Steuereinrichtung 4 umfasst eine Verarbeitungseinheit 12, die den synthetischen Jet 3 zur Abgabe der Fluidstöße 11 ansteuert und mit einer Signalerzeugungseinheit 13 verbunden ist. Daneben ist bei der elektrischen Anordnung 1 eine Erfassungseinheit 14 vorgesehen, die zum Detektieren einer Aktivierung der Leuchtdiode 8 einen eine Änderung der Strahlungsstärke des emittierten Lichts der Leuchtdiode 8 erfassenden Sensor 15 und einen weiteren eine Änderung ihrer Leistungsaufnahme erfassenden Sensor 16 aufweist. Dieser misst den über die Zuleitung 10 durch die Leuchtdiode 8 fließenden Strom oder die über die Leuchtdiode 8 abfallende Spannung.

Die Signalerzeugungseinheit 13 ist dazu ausgebildet, einen zeitlichen Signalverlauf des Aktivierens und Deaktivierens der Leuchtdiode 8 vorzugeben. Der zeitliche Signalverlauf beschreibt dabei eine Pulsweitenmodulation mit einer Frequenz, die so hoch gewählt ist, dass das von der Leuchtdiode 8 emittierte Licht mit einer für das menschliche Auge als homogen wahrgenommenen scheinbaren Helligkeit abgestrahlt wird. Durch eine Veränderung des Tastverhältnisses der Pulsweitenmodulation ist diese Helligkeit veränderbar. Alternativ dazu kann der zeitliche Signalverlauf auch von einer externen Quelle, beispielsweise als ein zum Schalten des durch die Zuleitung 10 fließenden Stroms vorgesehenes Steuersignal oder durch einen bereits modulierten Stroms entlang der Zuleitung 10 vorgegeben werden.

Der synthetische Jet 3 wird nun zum mit einer jeweiligen Aktivierung der Leuchtdiode 8 synchronisierten Erzeugen der Fluidstöße 11 angesteuert. D.h., mit jeder Aktivierung der Leuchtdiode 8 wird ein Fluidstoß 11 auf die Baugruppe 2 abgegeben, wodurch diese exakt zu jenen Zeitpunkten mit kühlender Luft beaufschlagt wird, in denen sie sich auf aufgrund der Bestromung der Leuchtdiode 6 erwärmt. Diese Zeitpunkte können auf verschiedenen Wegen vorgegeben oder detektiert werden, wobei auch Kombinationen möglich sind:

Im einfachsten Fall erfolgt die Ansteuerung des synthetischen Jets 3 durch ein externes Steuersignal, also von außerhalb der elektrischen Anordnung 1, wobei eine dieses Steuersignal erzeugende Einrichtung auch gleichzeitig den zeitlichen Signalverlauf für die Leuchtdiode 8 vorgeben kann. Wird hingegen der zeitliche Signalverlauf der Aktivierung der Leuchtdiode 8 durch die Signalerzeugungseinheit 13 vorgegeben, kann die Verarbeitungseinheit 12 den Signalverlauf unmittelbar auswerten und daraus ein Ansteuerungssignal für den synthetischen Jet 3 generieren.

Alternativ dazu kann der Signalverlauf auch mittels Sensordaten der Erfassungseinheit 14 durch die Verarbeitungseinheit 12 detektiert werden. Dazu erfasst der Sensor 15 die Änderung der Strahlungsstärke der Leuchtdiode 6 bei einer Aktivierung und Deaktivierung, woraus der Signalverlauf durch die Verwaltungseinheit 12 ableitbar ist. Analog dazu erfasst der Sensor 16 eine Änderung der Leistungsaufnahme der Leuchtdiode 8 durch eine Erfassung des durch die Zuleitung 10 fließenden Stroms oder der über die Leuchtdiode 8 abfallenden Spannung. Die die Änderung der Leistungsaufnahme beschreibenden Sensordaten werden anschließend durch die Verarbeitungseinheit 12 zur Synchronisierung der Abgabe der Fluidstößen 11 durch den synthetischen Jet 3 ausgewertet.

Zur Erläuterung der genauen zeitlichen Ansteuerung der Abgabe der Fluidstößen 11 zeigt Fig. 2 ein Diagramm des zeitlichen Verlaufs der Stromstärke 17 durch die Leuchtdiode 8, ihrer Sperrschichttemperatur 18 und eine Intensität 19 der Fluidstöße 11 über die Zeit t.

Ersichtlich wird die Leuchtdiode 8 gemäß einer Pulsweitenmodulation mit der Periodendauer T aktiviert und deaktiviert, wodurch sich ihre Sperrschichttemperatur 18 erhöht. Unmittelbar vor Erreichen der bauartbedingt für die Leuchtdiode 8 vorgegebenen maximalen Betriebssperrschichttemperatur θ_{J,max} wird ein Fluidstoß 11 ausgelöst, der die Baugruppe 2 mit der eingezeichneten Intensität 19 erreicht. Er bewirkt die Kühlung der Leuchtdiode 8 derart, dass die maximale Betriebssperrschichttemperatur θ_{J,max} zu keinem Zeitpunkt überschritten wird. Der Zeitpunkt, an dem der Fluidstoß 11 abgegeben wird, bestimmt sich dabei anhand seines räumlichen Abstands zur Baugruppe 2 sowie anhand empirischer, in der Verarbeitungseinheit 12 abgelegter Betriebsinformationen, die das Ansteigen der Sperrschichttemperatur 19 in Abhängigkeit der Stromstärke 17 beschreiben.

In einem weiteren Ausführungsbeispiel einer elektrischen Anordnung 1 gemäß Fig. 1 umfasst das Bauelement 6 eine Laserdiode anstelle der Leuchtdiode 8.

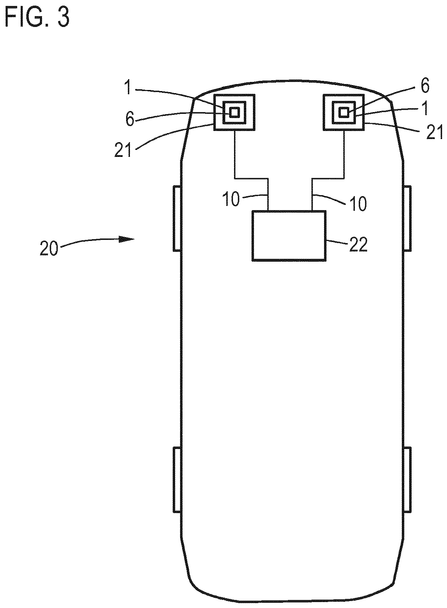

Fig. 3 zeigt eine Prinzipskizze eines Kraftfahrzeugs 20 mit zwei Scheinwerfern 21, welche jeweils eine elektrische Anordnungen 1 gemäß Fig. 1 aufweisen. Diese sind jeweils mittels eines Bordnetzes 22 über ihre Zuleitungen 10 versorgbar, wobei ihr Bauelement 6 als Lichtquelle des Scheinwerfers 21 dient.

## Patentansprüche

1. Elektrische Anordnung für ein Kraftfahrzeug (20), umfassend eine ein elektrisches Bauelement (6) aufweisende Baugruppe (2) und einen zum Erzeugen von Fluidstößen (11) ausgebildeten synthetischen Jet (3), welcher zur Abgabe der Fluidstöße (11) in Richtung der Baugruppe (2) angeordnet ist,
**dadurch gekennzeichnet,**
**dass** das Bauelement (6) gemäß einem zeitlichen Signalverlauf aktivierbar und der synthetische Jet (3) zum mit einer jeweiligen Aktivierung des Bauelements (6) synchronisierten Erzeugen wenigstens eines Fluidstoßes (11) ansteuerbar ist.

2. Elektrische Anordnung nach Anspruch 1,
**dadurch gekennzeichnet,**
**dass** das Bauelement (6) eine Leuchtdiode (8) und/oder eine Laserdiode ist oder umfasst.

3. Elektrische Anordnung Anspruch 1 oder 2,
**dadurch gekennzeichnet,**
**dass** der Signalverlauf eine Pulsweitenmodulation beschreibt und/oder mittels des Signalverlaufs eine für das menschliche Auge als homogen wahrgenommene scheinbare Helligkeit des Licht emittierenden Bauelements (6) vorgebbar ist.

4. Elektrische Anordnung nach einem der vorhergehenden Ansprüche,
**dadurch gekennzeichnet,**
**dass** der synthetische Jet (3) zur Abgabe des Fluidstoßes (11) auf oder an einen mit dem Bauelement (6) thermisch verbundenen Wärmeleitkörper (9) und/oder zur Abgabe des Fluidstoßes (11) auf das Bauelement (6) selbst angeordnet ist.

5. Elektrische Anordnung nach einem der vorhergehenden Ansprüche,
**dadurch gekennzeichnet,**
**dass** der synthetische Jet (3) zum Ausstoßen von Luft als Fluid ausgebildet ist.

6. Elektrische Anordnung nach einem der vorhergehenden Ansprüche,
**dadurch gekennzeichnet,**
**dass** der synthetische Jet (3) derart ansteuerbar ist, dass der wenigstens eine Fluidstoß (11) nach dem Beginn der Aktivierung des Bauelements (6) auf der Baugruppe (2) auftrifft.

7. Elektrische Anordnung nach einem der vorhergehenden Ansprüche,
**dadurch gekennzeichnet,**
**dass** eine Steuereinrichtung (4) vorgesehen ist, mittels welcher das Bauelement (6) ansteuerbar ist.

8. Elektrische Anordnung nach Anspruch 7,
**dadurch gekennzeichnet,**
**dass** die Steuereinrichtung (4) eine zur Erzeugung des zeitlichen Signalverlaufs ausgebildete Signalerzeugungseinheit (13) aufweist.

9. Elektrische Anordnung nach Anspruch 7 oder 8,
**dadurch gekennzeichnet,**
**dass** eine Erfassungseinheit (14) vorgesehen ist, mittels welcher die Aktivierung des Bauelements (6) erfassbar ist, wobei die erfasste Aktivierung des Bauelements (6) durch eine Verarbeitungseinheit (12) der Steuereinrichtung (4) zum Ansteuern des synthetischen Jets (3) auswertbar ist.

10. Elektrische Anordnung nach Anspruch 9,
**dadurch gekennzeichnet,**
**dass** die Erfassungseinheit (14) einen Sensor (15) zum Erfassen einer Änderung einer Strahlungsstärke des elektromagnetische Wellen emittierenden Bauelements (6) und/oder einen Sensor (16) zum Erfassen einer Änderung der Leistungsaufnahme des Bauelements (6) umfasst.

11. Kraftfahrzeug, umfassend eine elektrische Anordnung (1) nach einem der vorhergehenden Ansprüche.

12. Verfahren zum Betreiben eines synthetischen Jets (3), welcher Fluidstöße (11) erzeugt und in Richtung einer ein elektrisches Bauelement (6) aufweisenden Baugruppe (2) abgibt,
**dadurch gekennzeichnet,**
**dass** der synthetische Jet (3) wenigstens einen Fluidstoß (11) synchronisiert mit einer gemäß einem zeitlichen Signalverlauf erfolgenden jeweiligen Aktivierung des Bauelements (6) erzeugt.

13. Verfahren nach Anspruch 12,
**dadurch gekennzeichnet,**
**dass** der wenigstens eine Fluidstoß (11) auf das Bauelement (6) und/oder auf einen mit dem Bauelement (6) thermisch verbundenen Wärmeleitkörper (9) abgegeben wird.

14. Verfahren nach Anspruch 12 oder 13,
**dadurch gekennzeichnet,**
**dass** die Aktivierung des Bauelements (6) erfasst wird und in Abhängigkeit der Erfassung der Aktivierung das Erzeugen des wenigstens einen Fluidstoßes (11) erfolgt.

15. Verfahren nach Anspruch 14,
**dadurch gekennzeichnet,**
**dass** zum Erfassen der Aktivierung eine Strahlungsstärke des elektromagnetische Wellen erzeugenden Bauelements (6) und/oder eine Leistungsaufnahme des Bauelements (6) gemessen wird.

16. Verfahren nach einem der Ansprüche 12 bis 15,
**dadurch gekennzeichnet,**
**dass** der wenigstens eine abgegebene Fluidstoß (11) nach dem Beginn der Aktivierung des Bauelements (6) auf die Baugruppe (2) auftrifft.

## Claims

1. Electric arrangement for a motor vehicle (20), comprising an assembly (2) having an electric component (6), and a synthetic jet (3), configured to generate fluid blasts (11), which is arranged for outputting the fluid blasts (11) in the direction of the assembly (2),
**characterised in**
**that** the component (6) can be activated according to a temporal signal course and the synthetic jet (3) can be controlled for the generation, synchronised with a respective activation of the component (6), of at least one fluid blast (11).

2. Electric arrangement according to claim 1,
**characterised in**
**that** the component (6) is or comprises a light diode (8) and/or a laser diode.

3. Electric arrangement claim 1 or 2,
**characterised in**
**that** the signal course describes a pulse width modulation and/or by means of the signal course an apparent brightness of the component (6) emitting light can be predetermined which is perceived by the human eye as being homogeneous.

4. Electric arrangement according to any of the preceding claims,
**characterised in**
**that** the synthetic jet (3) for outputting the fluid blast (11) is arranged on or at a heat conducting body (9) connected thermally with the component (6) and/or for outputting the fluid blast (11) is arranged on the component (6) itself.

5. Electric arrangement according to any of the preceding claims,
**characterised in**
**that** the synthetic jet (3) is configured to blast air as a fluid.

6. Electric arrangement according to any of the preceding claims,
**characterised in**
**that** the synthetic jet (3) can be controlled such that the at least one fluid blast (11) impacts on the assembly (2) after the start of the activation of the component (6).

7. Electric arrangement according to any of the preceding claims,
**characterised in**
**that** a control apparatus (4) is provided by means of which the component (6) can be controlled.

8. Electric arrangement according to claim 7,
**characterised in**
**that** the control apparatus (4) has a signal generating unit (13) configured to generate the temporal signal course.

9. Electric arrangement according to claim 7 or 8,
**characterised in**
**that** a recording unit (14) is provided by means of which the activation of the component (6) can be recorded, wherein the recorded activation of the component (6) can be evaluated by a processing unit (12) of the control apparatus (4) for controlling the synthetic jet (3).

10. Electric arrangement according to claim 9
**characterised in**
**that** the recording unit (14) comprises a sensor (15) for recording a change in a radiation strength of the component (6) emitting electromagnetic waves and/or a sensor (16) for recording a change in the power consumption of the component (6).

11. Motor vehicle comprising an electric arrangement (1) according to any of the preceding claims.

12. Method for operating a synthetic jet (3) which generates fluid blasts (11) and outputs them in the direction of an assembly (2) having an electric component (6),
**characterised in**
**that** the synthetic jet (3) generates at least one fluid blast (11) synchronised with a respective activation of the component (6) taking place according to a temporal signal course.

13. Method according to claim 12,
**characterised in**
**that** the at least one fluid blast (11) is outputted onto the component (6) and/or onto a heat conducting body (9) connected thermally with the component (6).

14. Method according to claim 12 or 13,
**characterised in**
**that** the activation of the component (6) is recorded and the generation of the at least one fluid blast (11) takes place depending on the recording of the activation.

15. Method according to claim 14,
**characterised in**
**that** for recording the activation, a radiation strength of the component (6) generating electromagnetic waves and/or a power consumption of the component (6) is measured.

16. Method according to any of claims 12 to 15
**characterised in**
**that** the at least one emitted fluid blast (11) impacts on the assembly (2) after the start of the activation of the component (6).

## Revendications

1. Agencement électrique pour un véhicule à moteur (20), comprenant un assemblage (2) présentant un composant électrique (6) et un jet synthétique (3) réalisé pour produire des impulsions de fluide (11), lequel est agencé dans le sens de l'assemblage (2) pour diffuser les impulsions de fluide (11),
**caractérisé en ce que**
le composant (6) peut être activé selon une courbe temporelle de signal et le jet synthétique (3) peut être commandé pour générer au moins une impulsion de fluide (11) synchronisée avec une activation respective du composant (6).

2. Agencement électrique selon la revendication 1,
**caractérisé en ce que**
le composant (6) est ou comprend une diode électroluminescente (8) et/ou une diode laser.

3. Agencement électrique la revendication 1 ou 2,
**caractérisé en ce que**
la courbe de signal décrit une modulation de largeur d'impulsion et/ou il est possible de prévoir, au moyen de la courbe de signal, une luminosité apparente perçue comme homogène par l'œil humain du composant (6) émettant la lumière.

4. Agencement électrique selon l'une quelconque des revendications précédentes,
**caractérisé en ce que**
le jet synthétique (3) est agencé pour diffuser les impulsions de fluide (11) sur ou au niveau d'un corps thermoconducteur (9) relié thermiquement au composant (6) et/ou pour diffuser les impulsions de fluide (11) sur le composant (6) lui-même.

5. Agencement électrique selon l'une quelconque des revendications précédentes,
**caractérisé en ce que**
le jet synthétique (3) est réalisé pour rejeter l'air sous forme de fluide.

6. Agencement électrique selon l'une quelconque des revendications précédentes,
**caractérisé en ce que**
le jet synthétique (3) peut être commandé de telle manière que l'au moins une impulsion de fluide (11) frappe l'assemblage (2) après le début de l'activation du composant (6).

7. Agencement électrique selon l'une quelconque des revendications précédentes,
**caractérisé en ce qu'**
un dispositif de commande (4), au moyen duquel le composant (6) peut être commandé, est prévu.

8. Agencement électrique selon la revendication 7,
**caractérisé en ce que**
le dispositif de commande (4) présente une unité de génération de signal (13) réalisée pour générer la courbe temporelle de signal.

9. Agencement électrique selon la revendication 7 ou 8,
**caractérisé en ce qu'**
une unité de saisie (14), au moyen de laquelle l'activation de l'élément (6) peut être saisie, est prévue, dans lequel l'activation saisie du composant (6) peut être évaluée par une unité de traitement (12) du dispositif de commande (4) pour commander le jet synthétique (3).

10. Agencement électrique selon la revendication 9,
**caractérisé en ce que**
l'unité de saisie (14) comprend un capteur (15) pour saisir un changement d'une intensité de rayonnement du composant émettant des ondes électromagnétiques (6) et/ou un capteur (16) pour saisir un changement de la consommation d'énergie du composant (6).

11. Véhicule à moteur comprenant un agencement électrique (1) selon l'une quelconque des revendications précédentes.

12. Procédé pour faire fonctionner un jet synthétique (3), lequel génère des impulsions de fluide (11) et les diffuse dans le sens d'un assemblage (2) présentant un composant électrique (6),
**caractérisé en ce que**
le jet synthétique (3) génère au moins une impulsion de fluide (11) synchronisée avec une activation respective du composant (6) qui a lieu selon une courbe temporelle de signal.

13. Procédé selon la revendication 12,
**caractérisé en ce que**
l'au moins une impulsion de fluide (11) est diffusée sur le composant (6) et/ou sur un corps thermoconducteur (9) relié thermiquement au composant (6).

14. Procédé selon la revendication 12 ou 13,
**caractérisé en ce que**
l'activation du composant (6) est saisie et la génération de l'au moins une impulsion de fluide (11) a lieu en fonction de la saisie de l'activation.

15. Procédé selon la revendication 14,
**caractérisé en ce qu'**
une intensité de rayonnement du composant générant des ondes électromagnétiques (6) et/ou une consommation d'énergie du composant (6) est mesurée pour détecter l'activation.

16. Procédé selon l'une quelconque des revendications 12 à 15,
**caractérisé en ce que**
l'au moins une impulsion de fluide (11) diffusée frappe l'assemblage (2) après le début de l'activation du composant (6).
